Europäisches Patentamt

European Patent Office

Office européen des brevets

(19)

(11) **EP 0 840 958 B1**

(12) **FASCICULE DE BREVET EUROPEEN**

(45) Date de publication et mention
de la délivrance du brevet:
**20.01.1999 Bulletin 1999/03**

(21) Numéro de dépôt: **96926427.4**

(22) Date de dépôt: **18.07.1996**

(51) Int Cl.⁶: **H03M 13/22**

(86) Numéro de dépôt international:
**PCT/FR96/01135**

(87) Numéro de publication internationale:
**WO 97/05702 (13.02.1997 Gazette 1997/08)**

(54) **ENTRELACEMENT/DESENTRELACEMENT D'ELEMENTS DE DONNEES**

VER- UND ENTSCHACHTELUNG VON DATENELEMENTEN

DATA ELEMENT INTERLEAVING/DEINTERLEAVING

(84) Etats contractants désignés:
**DE ES FI GB IT SE**

(30) Priorité: **27.07.1995 FR 9509274**

(43) Date de publication de la demande:
**13.05.1998 Bulletin 1998/20**

(73) Titulaire: **FRANCE TELECOM**
**75015 Paris (FR)**

(72) Inventeurs:
- **COMBELLES, Pierre**
  **F-35000 Rennes (FR)**
- **CASTELAIN, Damien**
  **F-35000 Rennes (FR)**
- **CALLONNEC, Denis**
  **F-35000 Rennes (FR)**

(74) Mandataire: **Martinet & Lapoux**
**BP 405 - Guyancourt**
**78055 St. Quentin en Yvelines Cédex (FR)**

(56) Documents cités:
EP-A- 0 627 821          WO-A-95/16311
FR-A- 2 592 258          US-A- 4 394 642
US-A- 5 042 033

- IBM TECHNICAL DISCLOSURE BULLETIN, vol.
  16, no. 5, Octobre 1973, NEW YORK US, pages
  1432-1436, XP002002616 OUCHI & PATEL:
  "Random access memory implementation of
  interlaced error correction codes"

## Description

La présente invention concerne l'entrelacement ou le désentrelacement d'éléments de données dans des blocs de données consécutifs d'un signal numérique.

Les éléments de données peuvent être des éléments ou symboles binaires, ou bien des groupes d'éléments binaires tels que mots occupant des intervalles temporels dans une trame d'un signal multiplexé à division du temps ou de fréquence. Les blocs peuvent être par exemple des unités de données de protocole, telles que paquets ou trames, ou des champs de données dans des paquets ou trames, ou bien encore des lignes ou trames d'un signal de télévision numérique. Selon encore un autre exemple, un bloc peut être composé de PQ bits répartis en P groupes de Q bits multiplexés en fréquence respectivement sur P porteuses.

Dans un émetteur, l'entrelacement consiste à ordonner les éléments dans chaque bloc d'une manière différente de l'ordre initial des éléments, afin que des éléments de données initialement consécutifs soient séparés par d'autres éléments de données en nombre relativement élevé dans le bloc d'éléments entrelacés à transmettre. L'entrelacement contribue ainsi à pallier du moins partiellement les phénomènes d'évanouissement dans un canal de transmission entre l'émetteur et un récepteur, en introduisant une diversité temporelle ou fréquentielle dans le signal numérique. En pratique, les éléments de données pour former des blocs d'éléments entrelacés sont entrelacés dans un entrelaceur relié par exemple à la sortie d'un codeur de correction d'erreur, dit également codeur canal, et à l'entrée d'un modulateur. Inversement, le signal numérique initial est reconstitué dans le récepteur par désentrelacement des éléments entrelacés dans chaque bloc au moyen d'un désentrelaceur par exemple interconnecté entre un démodulateur et d'un décodeur canal.

Selon une réalisation connue, l'entrelacement consiste à écrire les éléments de données de chaque bloc selon leur ordre naturel d'arrivée dans un circuit de mémoire, puis à lire les éléments de données du bloc selon une fonction d'entrelacement prédéterminée.

Le circuit de mémoire comprend deux mémoires RAM disposées en parallèle et contenant chacune N cellules d'éléments de données. L'entier N désigne le nombre d'éléments de données dans chaque bloc. L'une des mémoires fonctionne en écriture pendant que l'autre mémoire fonctionne en lecture, une période de bloc sur deux, et inversement à la période de bloc suivante. Si n variant de 0 à N-1 désigne le rang d'un élément de données dans un bloc entrant et t la durée d'un élément de données, les éléments de données $e_0$,... $e_n$,... $e_{N-1}$ d'un premier bloc entrant $BE_0$ de durée Nt sont écrits successivement aux instants 0,... nt,... (N-1)t dans les cellules d'une première des mémoires ayant des adresses 0,... n,... N-1. Puis à la période de bloc suivante [Nt, (2Nt - 1)t], les éléments de données d'un second bloc entrant $BE_1$ sont écrits dans les cellules de la seconde mémoire, tandis que les éléments de données du premier bloc précédent $BE_0$ sont lus dans la première mémoire suivant des adresses de lecture P(0),... P(n),... P(N-1). P désigne la fonction d'entrelacement prédéterminée, qui fait correspondre bijectivement une adresse d'écriture n à une adresse de lecture P(n). Après que tous les éléments du premier bloc soient entièrement lus dans la première mémoire, la seconde mémoire est adressée en lecture selon la fonction d'adresse P(n) pour entrelacer les éléments de données du second bloc. Ainsi les blocs de rangs pairs sont lus et écrits dans la première mémoire, et les blocs de rangs impairs sont lus et écrits dans la seconde mémoire.

Afin de réduire le coût de l'entrelacement, il peut être envisagé de n'utiliser qu'une seule mémoire de taille N ayant un bus de données entrantes pour les éléments des blocs entrants et un bus de données sortantes pour les éléments entrelacés des blocs sortants. Si W(nt) et R(nt) désignent les adresses d'écriture et de lecture à l'instant nt d'une période de bloc, il est nécessaire à chaque intervalle élémentaire nt, de lire un élément de données d'un bloc précédemment écrit et d'écrire un élément de données d'un bloc suivant dans une même cellule. En d'autres termes, il est nécessaire de satisfaire l'égalité W(nt) = R(nt).

En supposant que la mémoire est vidée pour y écrire un premier bloc entrant $B_0$, les éléments $e_{0,0}$ à $e_{0,(N-1)}$ du bloc $B_0$ sont écrits successivement dans les cellules d'adresses $R_0(0t) = 0$ à $R_0((N-1)t) = Ni$. A la seconde période de bloc suivante, dans les cellules d'adresses $R_1(0t)=P(0)$ à $R_1((N-1)t)=P(N-1)$ sont successivement lus les éléments entrelacés du premier bloc $B_0$ selon la fonction d'entrelacement P et sont écrits successivement les éléments $e_{1,0}$ à $e_{1,(N-1)}$ du bloc suivant $B_1$. Ainsi, l'adresse de lecture $R_1(nt)$ à l'instant nt dans la seconde période de bloc est égale à l'adresse d'écriture $W_0(P(n)t) = P(n)$. Plus généralement, pour le bloc de rang k, la relation de récurrence suivante doit être vérifiée:

$$R_k(nt) = W_{k-1}(P(n)t)$$

soit

$$R_k(nt) = R_{k-1}(P(n)t).$$

Sachant que $R_0(nt) = n$, puis $R_1(nt) = P(n)$,... alors $R_k(nt) = p^k(n)$.

Ainsi l'élément de rang P(n) du bloc $B_{k-1}$ qui a été écrit à l'instant P(n)t de la période d'écriture du bloc $B_{k-1}$, est lu à l'instant nt de la période d'écriture du bloc suivant $B_k$ et se retrouve au rang n dans le bloc entrelacé. Cette correspondance d'instants équivaut à celle entre la lecture de l'élément $e_n$ d'un bloc dans l'une des deux mémoires à l'instant P(n)t, et l'écriture de l'élément en à l'instant nt pendant la période de bloc précédente selon la réalisation connue.

De manière à appliquer la fonction d'entrelacement P à chaque période d'écriture/lecture de blocs, une suite d'adresses différente d'une période d'écriture/lecture à la suivante doit être produite. Lorsque k augmente et N est grand, il est très difficile de produire l'ensemble des suites d'adresses.

Toutefois, pour des fonctions d'entrelacement particulières, un cycle d'adressage apparaît. Après q périodes d'écriture/lecture de blocs, la suite d'adresses initiales 0 à N-1 est retrouvée:

$$R_q(nt) = W_q(nt) = n .$$

En d'autres termes, l'entier q minimal satisfaisant l'identité $P^q(n) = n$ est assez petit.

A titre d'exemple, une fonction d'entrelacement du type

$$P(n) = (a.(n+1) + b) \ [modulo \ N]$$

définie dans la demande de brevet FR-A-2706054 répond à cet objectif. Par exemple lorsque n varie de 0 à N - 1 = 16, a = 4 et b = 0, en référence à la figure 2 de la demande de brevet précitée, il faut q = 4 suites d'adresses pour retrouver la suite initiale d'adresses 0 à 16 selon le tableau suivant :

| n | P(n) | $P^2(n)$ | $P^3(n)$ | $P^4(n)= n$ |
|---|------|----------|----------|-------------|
| 0 | 4 | 3 | 16 | 0 |
| 1 | 8 | 2 | 12 | 1 |
| 2 | 12 | 1 | 8 | 2 |
| 3 | 16 | 0 | 4 | 3 |
| 4 | 3 | 16 | 0 | 4 |
| 5 | 7 | 15 | 13 | 5 |
| 6 | 11 | 14 | 9 | 6 |
| 7 | 15 | 13 | 5 | 7 |
| 8 | 2 | 12 | 1 | 8 |
| 9 | 6 | 11 | 14 | 9 |
| 10 | 10 | 10 | 10 | 10 |
| 11 | 14 | 9 | 6 | 11 |
| 12 | 1 | 8 | 2 | 12 |
| 13 | 5 | 7 | 15 | 13 |
| 14 | 9 | 6 | 11 | 14 |
| 15 | 13 | 5 | 7 | 15 |
| 16 | 0 | 4 | 3 | 16 |

La présente invention vise à réduire le cycle d'adressage inhérent à l'usage d'une seule mémoire pour entrelacer les éléments de données bloc par bloc, et par conséquent à réduire la complexité des moyens nécessaires à produire les adresses de la mémoire. L'égalité $P^q(n) = n$, c'est-à-dire $P^4(n) = n$ selon le tableau ci-dessus, impose une contrainte élevée sur la fonction P.

A cette fin, un procédé pour modifier l'ordre, c'est-à-dire entrelacer (ou désentrelacer), des éléments de données dans des premiers et seconds blocs transmis alternativement et ayant chacun N éléments de données de rang n compris entre 0 et N-1, N étant un entier, est caractérisé en ce que les éléments de données ayant des rangs 0, ...n, ...N dans les premiers blocs sont ordonnés selon les rangs successifs A(0), ...A(n), ...A (N) et les éléments de données ayant des rangs 0, ... n, ...N dans les seconds blocs sont ordonnés selon les rangs successifs $A^{-1}(0)$, ...$A^{-1}(n)$, ...$A^{-1}(N)$, A et $A^{-1}$ étant des première et seconde fonctions différentes telles que $A^{-1}(A(n)) = n$.

En pratique, les opérations suivantes sont effectuées dans une mémoire ayant N cellules d'éléments de données avec des adresses 0 à N-1 et relatives à un premier bloc, un second bloc suivant et un premier bloc suivant:

a) - lecture d'éléments du premier bloc ordonnés selon la première fonction A et écriture d'éléments du second bloc suivant simultanées dans la mémoire de façon qu'un élément ayant un rang A(n) dans le premier bloc soit lu dans une cellule ayant l'adresse A(n) et un élément ayant le rang n dans le second bloc suivant soit écrit dans la cellule ayant l'adresse A(n), et

b) - lecture d'éléments du second bloc suivant ordonnés selon la seconde fonction $A^{-1}$ et écriture d'éléments du premier bloc suivant simultanées dans la mémoire de façon qu'un élément ayant le rang $A^{-1}(n)$ dans le second bloc suivant soit lu dans une cellule ayant l'adresse n et un élément ayant le rang n dans le premier bloc suivant soit écrit la cellule ayant l'adresse n.

Selon une variante, la mémoire est remplacée par des première et seconde mémoires qui sont adressées en écriture et lecture alternativement au rythme des éléments de données pour y écrire et lire les éléments de données respectivement ayant des rangs pairs et rangs impairs dans chacun des blocs. Dans ce cas, l'entier N est pair, et les entiers A(n) et n ont une même parité, et l'adresse d'écriture d'un élément de rang n est égale à l'adresse de lecture de l'élément de rang précédent n-1.

D'autres caractéristiques et avantages de la présente invention apparaitront plus clairement à la lecture de la description suivante de plusieurs réalisations préférées de l'invention en référence aux dessins annexés correspondants dans lesquels:

- la figure 1 est un bloc-diagramme d'un système de transmission dans lequel l'émetteur et le récepteur comprennent respectivement un entrelaceur et un désentrelaceur mettant en oeuvre le procédé selon l'invention;

- la figure 2 est un bloc-diagramme de l'entrelaceur selon une première réalisation;
- les figures 3A et 3B sont un tableau d'adresses de la mémoire d'éléments de données incluse dans l'entrelaceur, relativement à trois blocs d'éléments de données consécutifs; et
- la figure 4 est un bloc-diagramme partiel de l'entrelaceur selon une seconde réalisation.

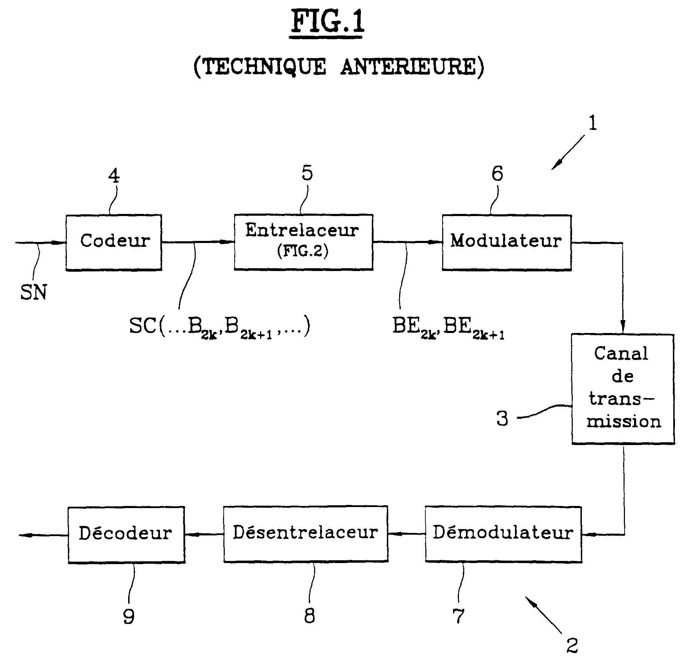

En référence à la figure 1, un système de transmission est composé d'un émetteur 1 et d'un récepteur 2 reliés par un canal de transmision 3, par exemple un canal radiophonique.

L'émetteur 1 comprend un codeur 4 recevant un signal numérique SN, un entrelaceur 5 et un modulateur 6. Le codeur 4 effectue un codage linéaire de correction d'erreur en bloc, par exemple de type Reed-Solomon, pour produire un signal numérique codé SC. Le signal SC est composé de symboles d'information et de contrôle formant des blocs... $B_{2k}$, $B_{2k+1}$,... ayant chacun un nombre prédéterminé N d'éléments de données... [$e_{2k,0}$ à $e_{2k,N-1}$], [$e_{2k+1,0}$ à $e_{2k+1,N-1}$]... En l'occurrence, les éléments de données sont des bits. Le codage linéaire de correction d'erreurs permet de corriger les erreurs isolées et erratiques qui peuvent survenir même lors de faible perturbation dans le canal de transmission 3.

L'entrelaceur 5 entrelace les éléments de données dans les blocs $B_{2k}$, $B_{2k+1}$ selon le procédé d'entrelacement de l'invention. L'entrelacement avant l'émission du signal numérique sépare des éléments de données initialement consécutifs par un nombre relativement élevé d'autres éléments de données dans un bloc afin qu'une perturbation telle qu'évanouissement du canal de transmission 3 n'affecte que l'un ou quelques-uns des éléments consécutifs. Une telle précaution facilite la reconstitution du signal numérique initial dans le récepteur 2 puisqu'un élément de données perturbé est a priori encadré par des éléments de données non perturbés dans le signal numérique SN.

L'entrelaceur 5 produit des blocs d'éléments entrelacés $BE_{2k}$, $BE_{2k+1}$ constituant un flux entrelacé qui est converti en un signal modulé dans le modulateur 6 suivant une modulation numérique quelconque.

Le récepteur 2 effectue les fonctions inverses de celles de l'émetteur 1. Le récepteur 2 comprend à cet effet sucessivement un démodulateur 7, un désentrelaceur 8 désentrelaçant les éléments entrelacés des blocs $BE_{2k}$, $BE_{2k+1}$ sortant du démodulateur en des blocs $B_{2k}$, $B_{2k+1}$, et un décodeur 9 effectuant un décodage linéaire en bloc de symboles du même type que le codage dans le codeur 4. En particulier, le désentrelaceur 8 désentrelace des éléments de données reçus selon une fonction de désentrelacement conforme à l'invention.

Dans la suite, le mot "entrelaceur" et les mots de la même famille que celui-ci peuvent être remplacés par le mot "désentrelaceur" et les mots de la même famille que celui-ci, puisque l'entrelaceur et le désentrelaceur effectuent les mêmes fonctions. Bien que l'objet de la présente demande de brevet concerne un procédé d'entrelacement, celui-ci concerne également un procédé de désentrelacement.

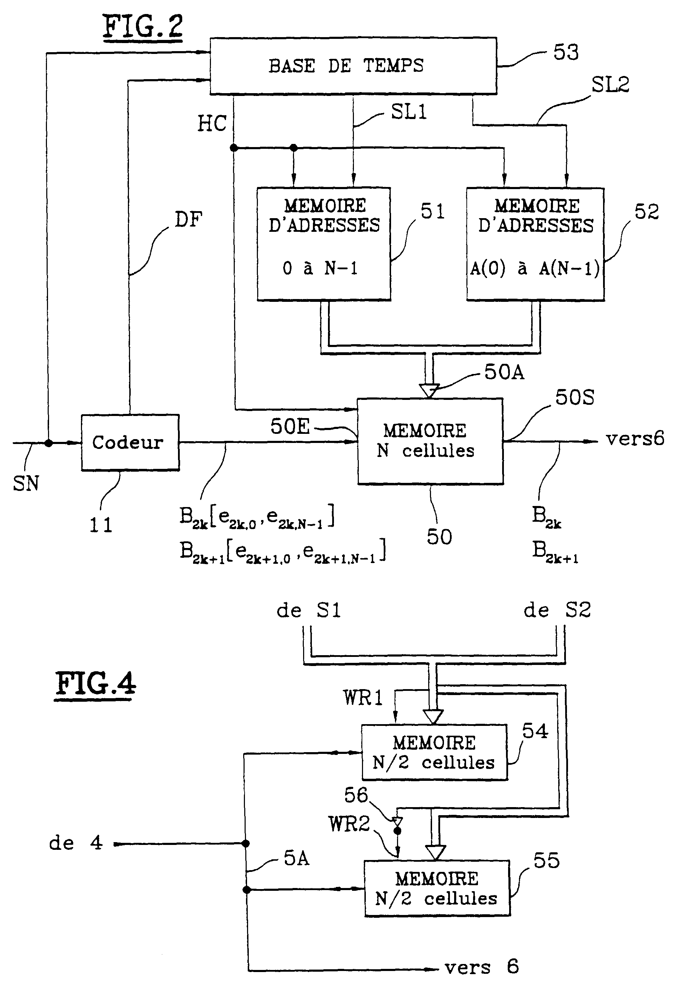

Selon une première réalisation montrée à la figure 2, l'entrelaceur 5 comprend une unique mémoire RAM 50 ayant N cellules. Chaque cellule est capable de mémoriser un élément de données. La mémoire 50 présente deux accès de données 50E et 50S. L'accès d'entrée 50E reçoit les blocs initiaux $B_{2k}$, $B_{2k+1}$, élément par élément, du codeur 4. L'accès de sortie 50S applique les blocs sortants d'éléments entrelacés $BE_{2k}$, $BE_{2k+1}$, élément par élément, au modulateur 6. Lorsque les éléments de données comprennent chacun plusieurs bits, les accès 50E et 50S sont un bus d'entrée reliant un convertisseur série-parallèle à la mémoire, et un bus de sortie reliant la mémoire à un convertisseur parallèle-série.

Selon l'invention, une fonction d'entrelacement A ayant des propriétés déterminées pour la transmission dans le canal de transmission 3 est appliquée à un bloc sur deux produits par le codeur 4. Par exemple, la fonction A est appliquée à des premiers blocs de rang pair $B_0$,... $B_{2k}$, $B_{2k+2}$,... où k est un entier. On se réfère par exemple au bloc $B_{2k}$ comprenant N éléments de données $e_{2k,0}$,... $e_{2k,n}$,... $e_{2k,N-1}$ où n est un entier compris entre 0 et N-1.

Lorsque les éléments $e_{2k,0}$ à $e_{2k,N-1}$ du premier bloc $B_{2k}$ sont appliqués consécutivement par l'accès d'entrée 50E à la mémoire 50, une première mémoire d'adresses PROM 51 applique successivement des adresses de lecture/écriture $RW_{2k}(0) = 0$ à $RW_{2k}((N-1)t) = N-1$. Chaque période d'une horloge de commande HC produite par un base de temps 53 en synchronisation avec l'horloge bit du signal numérique initial SN est divisée en deux parties. Par exemple pour l'élément $e_{2k,n}$, pendant la première partie de période d'horloge un élément de données de bloc précédent $B_{2k-1}$ écrit dans la cellule ayant l'adresse $RW_{2k}(nt) = n$ est lu. Pendant la seconde partie de la période d'horloge, l'élément de données $e_{2k,n}$ du bloc $B_{2k}$ est écrit dans la cellule ayant l'adresse n, soit à l'instant nt à compter du début du bloc $B_{2k}$.

Puis à la période de bloc suivante, le second bloc $B_{2k+1}$ est présenté à l'accès d'entrée 50E. A l'instant nt à compter du début de la période de bloc suivante, une seconde mémoire d'adresses PROM 52 applique l'adresse de lecture/écriture $RW_{2k+1}(nt) = A(n)$. Pendant la première partie de la période correspondante du signal d'horloge HC, l'élément de données $e_{2k,A(n)}$ du bloc $B_{2k}$ est lu dans la cellule ayant l'adresse A(n). Pendant la seconde partie de la période d'horloge correspondante, dans la cellule ayant l'adresse A(n) est écrit l'élément de données $e_{2k+1,n}$ du second bloc $B_{2k+1}$. Le premier bloc $B_{2k}$ a ainsi ses éléments de données entrelacés selon la fonction A(n).

Au cours de la prochaine période de bloc, le premier bloc suivant $B_{2k+2}$ est ensuite traité de la même manière que le bloc $B_{2k}$ dans la mémoire 50. Les adresses de

lecture/écriture RW$_{2k+2}$(nt) = n sont produites par la première mémoire d'adresses 51 pour lire/écrire successivement dans les N cellules de la mémoire 50 selon l'ordre naturel des adresses 0 à Ni. Lors des premières parties des périodes d'horloge correspondant à l'écriture des éléments e$_{2k+2,0}$ 0 à e$_{2k+2,N-1}$ du bloc B$_{2k+2}$, les éléments du bloc précédent B$_{2k+1}$ écrits suivant la fonction d'entrelacement A(n) sont lus séquentiellement selon une autre fonction d'entrelacement A$^{-1}$ tel que A$^{-1}$(A(n)) = n, quel que soit l'entier n compris entre 0 et N-1.

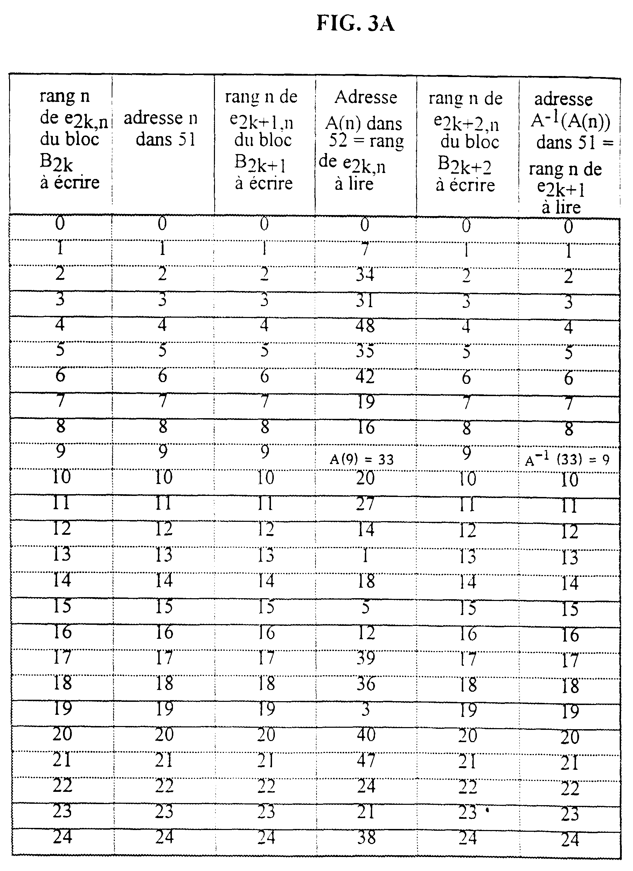

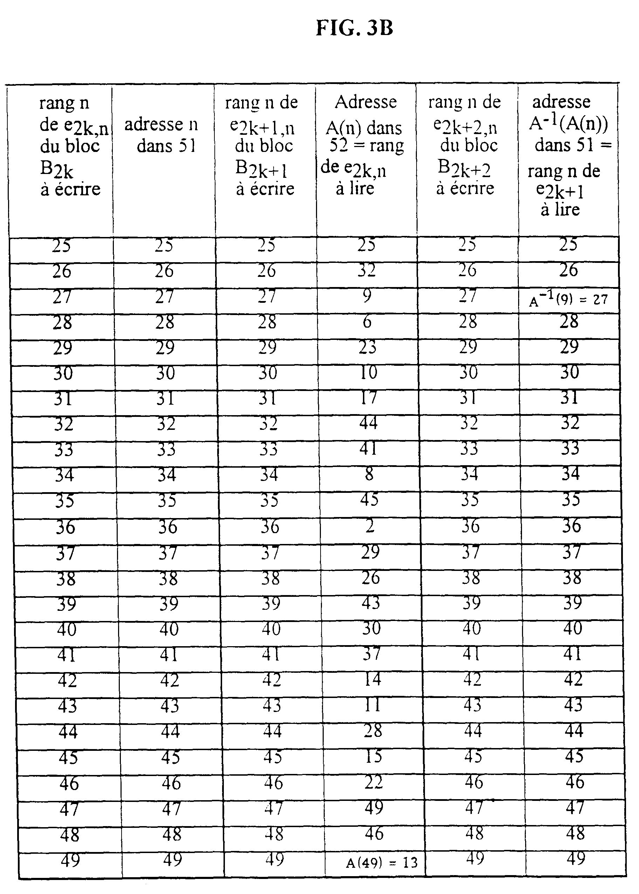

Les figures 3A et 3B montrent trois colonnes d'adresse de lecture/écriture appliquées aux mémoires 51, 52 ,51 pendant trois périodes de bloc successives au cours desquelles le premier bloc B$_{2k}$, le second bloc B$_{2k+1}$ et le premier bloc suivant B$_{2k+2}$ sont appliqués à l'accès d'entrée de mémoire 50E. Pour chacune des périodes, les adresses de lecture/écriture et les rangs des éléments de données à lire et à écrire sont indiqués.

A titre d'exemple, les indices n indiqués dans les figures 3A et 3B correspondent à la fonction d'entrelacement suivante:

$$A(n+1) = a.A(n) + b \ [\text{modulo } N],$$

avec n=0, ...N-1.

Cette fonction peut également s'écrire directement en fonction de n:

$$A(n) = b \sum_{i=1}^{i=n} a^{i-1} \ [\text{modulo } N]$$

soit A(n) = b(1-a$^n$)/(1-a) [modulo N]
avec a = 11, b = 7 et N = 50.

Par exemple, à l'instant nt = 9t pendant les trois périodes de bloc successives, l'élément e$_{2k-1,27}$ du bloc BE$_{2k-1}$ est lu et l'élément e$_{2k,9}$ est écrit dans la cellule d'adresse 9, puis l'élément e$_{2k,33}$ du bloc BE$_{2k}$ est lu et l'élément e$_{2k+1,9}$ du bloc B$_{2k+1}$ est écrit dans la cellule d'adresses 33, et ensuite l'élément e$_{2k+1,27}$ du bloc BE$_{2k+1}$ est lu et l'élément e$_{2k+2,9}$ du bloc B$_{2k+2}$ est écrit dans la cellule d'adresse 9, telle que A$^{-1}$(A(9)) = A$^{-1}$(33) = 9 et A$^{-1}$(9) = 27.

Selon un autre exemple, une cellule d'adresse n = 6 transmet les éléments de rang 28, tel que e$_{2k-1,28}$, e$_{2k+1,28}$ des seconds blocs B$_{2k-1}$, B$_{2k+1}$, et reçoit les éléments de rang 6, tel que e$_{2k,6}$, e$_{2k+2,6}$ des premiers blocs B$_{2k}$, B$_{2k+2}$ pendant la période d'horloge de lecture/écriture de rang n = 6 pendant des premières périodes de bloc. La cellule d'adresse n = 6 transmet les éléments de rang 6, tels que e$_{2k,6}$, e$_{2k+2,6}$ des premiers blocs B$_{2k}$, B$_{2k+2}$ et reçoit les éléments de rang 28, tels que e$_{2k-1,28}$, e$_{2k+1,28}$ pendant la période d'horloge de lecture/écriture de rang n = 28 pendant des secondes périodes de bloc alternées avec les premières périodes de bloc.

En pratique, l'entrelaceur 5 montré à la figure 2 comprend une base de temps 53 qui reçoit le signal numérique SN à coder et transmettre et des informations de début/fin de bloc DF du codeur 4. La base de temps contient notamment des compteurs et diviseurs de fréquence notamment pour produire le signal d'horloge de commande de lecture/écriture HC en synchronisation avec l'horloge bit à la sortie du codeur 4, un premier signal de lecture SL1 pendant les premières périodes de bloc pour lire les adresses 0 à N-1 dans la première mémoire d'adresses 51 et les appliquer à une entrée d'adressage 50A de la mémoire 50, et un second signal de lecture SL2 pendant les secondes périodes de bloc pour lire les adresses A(0) à A(N-1) dans la seconde mémoire d'adresses 52 et les appliquer à l'entrée d'adressage 50A de la mémoire 50.

Selon une variante, la première mémoire 51 peut être remplacée par un compteur modulo N pour adresser la mémoire 50 pendant les premières périodes de bloc et pour adresser la mémoire 52 pendant les secondes périodes de bloc.

Le désentrelaceur 8 dans le récepteur 2 comprend également une mémoire RAM à N cellules, deux mémoires d'adresses PROM et une base de temps agencées de la même manière que dans l'entrelaceur montré à la figure 2. Le désentrelacement des blocs fait appel aux mêmes fonctions d'entrelacement A et A$^{-1}$, mais interchangées par rapport aux blocs. Ainsi, les premiers blocs d'éléments entrelacés BE$_{2k}$, BE$_{2k+2}$ sont désentrelacés en des blocs B$_{2k}$, B$_{2k+2}$ selon la fonction A$^{-1}$ et les seconds blocs d'éléments entrelacés BE$_{2k-1}$, BE$_{2k+1}$ sont désentrelacés en des blocs B$_{2k-1}$, B$_{2k+1}$ selon la fonction A. Comme cela apparait dans la figure 3, il suffit de lire le tableau de la droite vers la gauche avec un décalage d'un bloc.

Selon une autre réalisation, la mémoire à double accès de données 50E et 50S peut être remplacée par une mémoire du type à simple accès de données ayant N cellules d'élément de données.

Si un simple accès de données est utilisé, à l'instant nt il faut d'abord lire l'élément de données du bloc courant BE$_K$ ayant le rang n-1, puis écrire l'élément de données du bloc précédent B$_{K-1}$ mémorisé dans la cellule de rang n,
soit R$_K$(n-1) = W$_K$(n) si n ≠ 0.

Lorsque n = 0, la relation précédente s'écrit R$_{K-1}$(N-1) = W$_K$(0) puisqu'à l'instant 0 du bloc courant B$_K$, il faut lire le dernier élément de données du bloc précédent BE$_{K-1}$ avant d'écrire le premier élément de données du bloc suivant. En raison du décalage temporel du cycle d'adressage de lecture, il est nécessaire que, lors de la mémorisation d'un bloc au suivant, la dernière adresse de lecture du premier bloc et la première adresse de lecture du bloc suivant soient différentes, afin d'éviter de lire le premier élément du bloc suivant immédiatement après son écriture, soit

$$R_{K-1}(N-1) = W_K(0) \neq R_K(0)$$

Cette condition se traduit par:

1) $R_{2k-1}(N-1) \neq R_{2k}(0)$ lorsque K = 2k, c'est-à-dire lorsque le bloc $B_K = B_{2k}$ est un premier bloc de rang pair, soit $A(N-1) \neq 0$ ; et

2) $R_{2k}(N-1) \neq R_{2k+1}(0)$ lorsque K = 2k + 1, c'est-à-dire lorsque le bloc $B_K = B_{2k+1}$ est un second bloc de rang impair, soit $N-1 \neq A(0)$.

Les deux conditions précédentes peuvent être satisfaites lorsque A(n) et n sont de même parité, soit A(n) [modulo 2] = n [modulo 2].

Comme montré à la figure, la mémoire 50 est alors remplacée par deux mémoires RAM 54 et 55 ayant une capacité de N/2 cellules, N étant pair. Les mémoires ont un simple accès de données commun 5A relié à la sortie du codeur 4 et à l'entrée du modulateur 6. Lorsque l'une des mémoires 54 et 55 est adressée en écriture, l'autre mémoire est adressée en lecture afin de satisfaire la relation énoncée ci-dessous

$R_K(n-1) = W_K(n)$ à l'instant nt de chaque bloc, avec $R_K(n-1) = n-1$ lorsque K = 2k, et $R_K(n-1) = A(n-1)$ lorsque K = 2k + 1.

Dans cette seconde réalisation, le bit de poids faible 60 dans les adresses lues dans les mémoires d'adresses 51 et 52 est appliqué directement et à travers un inverseur 56 à des entrées d'autorisation d'écriture/lecture WR1 et WR2 des mémoires 54 et 55 pour commander l'alternance en écriture/lecture des deux mémoires.

A titre d'exemple pratique, les fonctions d'entrelacement suivantes peuvent être choisies, pour cette seconde réalisation :

$$A(n) = 4740\,n^2 + 1623\,n + 2526 \ [\text{modulo } 12640]$$

avec $0 \leq n < 12640 = N$, et

$$A^{-1}(n) = 4740\,n^2 + 4887\,n + 11038 \ [\text{modulo } 12640].$$

## Revendications

1. Procédé pour modifier l'ordre des éléments de données dans des premiers et seconds blocs ($B_{2k}$, $B_{2k+1}$) transmis alternativement et ayant chacun N éléments de données de rang n compris entre 0 et N-1, N étant un entier, caractérisé en ce que les éléments de données ayant des rangs 0, ...n, ...N dans les premiers blocs ($B_{2k}$) sont ordonnés selon les rangs successifs A(0), ...A(n), ...A(N) et les éléments de données ayant des rangs 0, ...n, ...N dans les seconds blocs ($B_{2k+1}$) sont ordonnés selon les rangs successifs $A^{-1}(0)$, ...$A^{-1}(n)$, ...$A^{-1}(N)$, A et $A^{-1}$ étant des première et seconde fonctions différentes telles que $A^{-1}(A(n)) = n$.

2. Procédé conforme à la revendication 1, caractérisé par les opérations suivantes dans une mémoire (50) ayant N cellules d'éléments de données avec des adresses 0 à N-1 et relatives à un premier bloc ($B_{2k}$), un second bloc suivant ($B_{2k+1}$) et un premier bloc suivant ($B_{2k+2}$):

   a) - lecture d'éléments du premier bloc ($B_{2k}$) ordonnés selon la première fonction A et écriture d'éléments du second bloc suivant ($B_{2k+1}$) simultanées dans la mémoire de façon qu'un élément ayant un rang A(n) dans le premier bloc ($B_{2k}$) soit lu dans une cellule ayant l'adresse A(n) et un élément ayant le rang n dans le second bloc suivant ($B_{2k+1}$) soit écrit dans la cellule ayant l'adresse A(n), et

   b) - lecture d'éléments du second bloc ($B_{2k+1}$) ordonnés selon la seconde fonction $A^{-1}$ et écriture d'éléments du premier bloc suivant ($B_{2k+2}$) simultanées dans la mémoire de façon qu'un élément ayant le rang $A^{-1}(n)$ dans le second bloc suivant ($B_{2k+1}$) soit lu dans une cellule ayant l'adresse n et un élément ayant le rang n dans le premier bloc suivant ($B_{2k+2}$) soit écrit la cellule ayant l'adresse n.

3. Procédé conforme à la revendication 2, selon lequel l'entier N est pair, les entiers A(n) et n ont une même parité, et la mémoire (50) est remplacée par des première et seconde mémoires (54, 55), qui sont adressées en écriture et lecture alternativement au rythme des éléments de données pour y écrire et lire les éléments de données respectivement ayant des rangs pairs et des rangs impairs dans chacun des blocs.

## Patentansprüche

1. Verfahren zur Änderung der Ordnung der Datenelemente in ersten und zweiten Blöcken ($B_{2k}$, $B_{2k+1}$), die abwechselnd übertragen werden und jeweils N Datenelemente der Nummer n aufweisen, wobei n zwischen 0 und N-1 liegt und N ganzzahlig ist, dadurch gekennzeichnet, dass die Datenelemente mit der Nummer 0,...n,...N in den ersten Blöcken ($B_{2k}$) nach den aufeinanderfolgenden Nummern A(0),... A(n),...A(N) geordnet sind und die Datenelemente mit den Nummern 0,...n,...N in den zweiten Blöcken ($B_{2k+1}$) nach den aufeinanderfolgenden Nummern $A^{-1}(0)$,...$A^{-1}(n)$,...$A^{-1}(N)$ geordnet sind, wobei A und $A^{-1}$ eine erste und eine zweite, voneinander verschiedene Funktionen sind, derart dass $A^{-1}(A(n)) = n$.

2. Verfahren nach Patentanspruch 1, gekennzeichnet durch die folgenden Vorgänge in einem Speicher (50), der über N Datenelementzellen mit Adressen 0 bis N-1 verfügt, die sich auf einen ersten Block ($B_{2k}$), einen zweiten folgenden Block ($B_{2k+1}$) und einen ersten folgenden Block ($B_{2k+2}$) beziehen:

    a) - gleichzeitiges Lesen von Elementen des ersten Blockes ($B_{2k}$), geordnet nach der ersten Funktion A, und Schreiben von Elementen des zweiten folgenden Blockes ($B_{2k+1}$) in den Speicher, derart dass ein Element mit der Nummer A(n) im ersten Block ($B_{2k}$) in einer Zelle gelesen wird, die die Adresse A(n) hat, und ein Element mit der Nummer n im zweiten folgenden Block ($B_{2k+1}$) in die Zelle geschrieben wird, die die Adresse A(n) hat, und

    b) - gleichzeitiges Lesen von Elementen des zweiten Blockes ($B_{2k+1}$), geordnet nach der zweiten Funktion $A^{-1}$, und Schreiben von Elementen des ersten folgenden Blockes ($B_{2k+2}$) in den Speicher, derart dass ein Element mit der Nummer $A^{-1}(n)$ im zweiten folgenden Block ($B_{2k+1}$) in einer Zelle gelesen wird, die die Adresse n hat, und ein Element mit der Nummer n im ersten folgenden Block ($B_{2k+2}$) in die Zelle geschrieben wird, die die Adresse n hat.

3. Verfahren nach Patentanspruch 2, in dem die ganze Zahl N gerade ist, die ganzen Zahlen A(n) und n die gleiche Parität haben und der Speicher (50) durch einen ersten und einen zweiten Speicher (54, 55) ersetzt wird, die abwechselnd im Rythmus der Datenelemente zum Schreiben und Lesen adressiert werden, um darin die Datenelemente zu schreiben und zu lesen, die gerade bzw. ungerade Nummern in jedem der Blöcke aufweisen.

**Claims**

1. A method of modifying the order of data elements in first and second blocks ($B_{2k}$, $B_{2k+1}$) transmitted alternately and each having N data elements with rank n lying between 0 and N-1, N being an integer, characterized in that the data elements with ranks 0, ...n, ...N in the first blocks ($B_{2k}$) are ordered in accordance with the successive ranks A(0), ...A(n), ... A(N) and the data elements having ranks 0, ...n, ... N in the second blocks ($B_{2k+1}$) are ordered in accordance with the successive ranks $A^{-1}(0)$, ... $A^{-1}(n)$, ... $A^{-1}(N)$, A and $A^{-1}$ being different first and second functions such that $A^{-1}(A(n)) = n$.

2. A method according to claim 1, characterized by the following operations in a memory (50) having N data element cells with addresses 0 through N-1 and relating to a first block ($B_{2k}$), a second next block ($B_{2k+1}$) and a first next block ($B_{2k+2}$):

    a) - reading elements of the first block ($B_{2k}$) ordered in accordance with the first function A and simultaneously writing elements of the second next block ($B_{2k+1}$) in the memory so that an element with a rank A(n) in the first block ($B_{2k}$) is read in a cell having the address A(n) and an element with the rank n in the second next block ($B_{2k+1}$) is written in the cell having the address A(n), and

    b) - reading elements of the second block ($B_{2k+1}$) ordered in accordance with the second function $A^{-1}$ and simultaneously writing elements of the first next block ($B_{2k+2}$) in the memory so that an element having the rank $A^{-1}(n)$ in the second next block ($B_{2k+1}$) is read in a cell having the address n and an element with the rank n in the first next block ($B_{2k+2}$) is written in the cell having the address n.

3. The method claimed in claim 2 characterized in that the integer N is even, the integers A(n) and n have the same parity, and the memory (50) is replaced by first and second memories (54, 55) which are addressed in write mode and in read mode alternately at the timing rate of the data elements in order to write and read therein the data elements respectively having even ranks and odd ranks in each of the blocks.

# FIG.1

## (TECHNIQUE ANTERIEURE)

## FIG.2

BASE DE TEMPS — 53

SL1

HC

SL2

DF

| MEMOIRE D'ADRESSES | 51 |
| 0 à N−1 | |

| MEMOIRE D'ADRESSES | 52 |
| A(0) à A(N−1) | |

50A

Codeur — 11

50E

MEMOIRE N cellules — 50

50S

vers6

SN

$B_{2k}[e_{2k,0}, e_{2k,N-1}]$
$B_{2k+1}[e_{2k+1,0}, e_{2k+1,N-1}]$

$B_{2k}$
$B_{2k+1}$

## FIG.4

de S1

de S2

WR1

MEMOIRE N/2 cellules — 54

56

WR2

de 4

5A

MEMOIRE N/2 cellules — 55

vers 6

# FIG. 3A

| rang n de $e_{2k,n}$ du bloc $B_{2k}$ à écrire | adresse n dans 51 | rang n de $e_{2k+1,n}$ du bloc $B_{2k+1}$ à écrire | Adresse $A(n)$ dans 52 = rang de $e_{2k,n}$ à lire | rang n de $e_{2k+2,n}$ du bloc $B_{2k+2}$ à écrire | adresse $A^{-1}(A(n))$ dans 51 = rang n de $e_{2k+1}$ à lire |
|---|---|---|---|---|---|
| 0 | 0 | 0 | 0 | 0 | 0 |
| 1 | 1 | 1 | 7 | 1 | 1 |
| 2 | 2 | 2 | 34 | 2 | 2 |
| 3 | 3 | 3 | 31 | 3 | 3 |
| 4 | 4 | 4 | 48 | 4 | 4 |
| 5 | 5 | 5 | 35 | 5 | 5 |
| 6 | 6 | 6 | 42 | 6 | 6 |
| 7 | 7 | 7 | 19 | 7 | 7 |
| 8 | 8 | 8 | 16 | 8 | 8 |
| 9 | 9 | 9 | $A(9) = 33$ | 9 | $A^{-1}(33) = 9$ |
| 10 | 10 | 10 | 20 | 10 | 10 |
| 11 | 11 | 11 | 27 | 11 | 11 |
| 12 | 12 | 12 | 14 | 12 | 12 |
| 13 | 13 | 13 | 1 | 13 | 13 |
| 14 | 14 | 14 | 18 | 14 | 14 |
| 15 | 15 | 15 | 5 | 15 | 15 |
| 16 | 16 | 16 | 12 | 16 | 16 |
| 17 | 17 | 17 | 39 | 17 | 17 |
| 18 | 18 | 18 | 36 | 18 | 18 |
| 19 | 19 | 19 | 3 | 19 | 19 |
| 20 | 20 | 20 | 40 | 20 | 20 |
| 21 | 21 | 21 | 47 | 21 | 21 |
| 22 | 22 | 22 | 24 | 22 | 22 |
| 23 | 23 | 23 | 21 | 23 | 23 |
| 24 | 24 | 24 | 38 | 24 | 24 |

## FIG. 3B

| rang n de $e_{2k,n}$ du bloc $B_{2k}$ à écrire | adresse n dans 51 | rang n de $e_{2k+1,n}$ du bloc $B_{2k+1}$ à écrire | Adresse $A(n)$ dans 52 = rang de $e_{2k,n}$ à lire | rang n de $e_{2k+2,n}$ du bloc $B_{2k+2}$ à écrire | adresse $A^{-1}(A(n))$ dans 51 = rang n de $e_{2k+1}$ à lire |
|---|---|---|---|---|---|
| 25 | 25 | 25 | 25 | 25 | 25 |
| 26 | 26 | 26 | 32 | 26 | 26 |
| 27 | 27 | 27 | 9 | 27 | $A^{-1}(9) = 27$ |
| 28 | 28 | 28 | 6 | 28 | 28 |
| 29 | 29 | 29 | 23 | 29 | 29 |
| 30 | 30 | 30 | 10 | 30 | 30 |
| 31 | 31 | 31 | 17 | 31 | 31 |
| 32 | 32 | 32 | 44 | 32 | 32 |
| 33 | 33 | 33 | 41 | 33 | 33 |
| 34 | 34 | 34 | 8 | 34 | 34 |
| 35 | 35 | 35 | 45 | 35 | 35 |
| 36 | 36 | 36 | 2 | 36 | 36 |
| 37 | 37 | 37 | 29 | 37 | 37 |
| 38 | 38 | 38 | 26 | 38 | 38 |
| 39 | 39 | 39 | 43 | 39 | 39 |
| 40 | 40 | 40 | 30 | 40 | 40 |
| 41 | 41 | 41 | 37 | 41 | 41 |
| 42 | 42 | 42 | 14 | 42 | 42 |
| 43 | 43 | 43 | 11 | 43 | 43 |
| 44 | 44 | 44 | 28 | 44 | 44 |
| 45 | 45 | 45 | 15 | 45 | 45 |
| 46 | 46 | 46 | 22 | 46 | 46 |
| 47 | 47 | 47 | 49 | 47 | 47 |
| 48 | 48 | 48 | 46 | 48 | 48 |
| 49 | 49 | 49 | $A(49) = 13$ | 49 | 49 |